# EUROPEAN PATENT APPLICATION

(11) **EP 1 837 931 A2**
(43) Date of publication of application: **26.09.2007**
(21) Application number: 07004966.3
(22) Date of filing: 09.03.2007
(51) Int. Cl.: H01L 51/52

(54) **Conductive transparent material, manufacturing method thereof and display device comprising the same**

(30) Priority: 21.03.2006 KR 20060025833
(71) Applicant: Samsung Electronics Co., Ltd., Seoul 442-742 (KR)
(72) Inventor: Oh, Joon-hak, Yongin-si Gyeonggi-do (KR); Lee, Yong-uk, Gwangju-si Gyeonggi-do (KR)
(74) Representative: Weitzel, Wolfgang

(57) **Abstract**

A method of manufacturing a conductive transparent material comprises providing a nano particle (10) which comprises a core (11) having a conductive polymer and a shell (12) surrounding at least a part of the core and comprising a first transparent polymer; providing a mixture by mixing a base powder comprising a second transparent polymer and the nano particle; and forming a conductive network in which the cores are connected with each other, by pressing the mixture.
Thus, the present invention provides a manufacturing method of a conductive transparent material which is highly conductive and transparent.

## Description

### CROSS-REFERENCE TO RELATED APPLICATIONS

This application claims the benefit of Korean Patent Application No.2006-0025833, filed on March 21, 2006, and all the benefits accruing therefrom under 35 USC 119(a), the content of which is incorporated herein by reference in its entirety.

### BACKGROUND OF THE INVENTION

### Field of the Invention

The present invention relates to a conductive transparent material, a manufacturing method thereof and a display device comprising the same.

### Description of the Related Art

A transparent electrode is employed in a liquid crystal display ("LCD"), an organic light emitting diode ("OLED") and an electrophoresis display device ("EPD"), and the like. The transparent electrode comprises metal oxide such as indium tin oxide ("ITO") and indium zinc oxide ("IZO").

Flexible displays have been drawing much attention recently, where such displays require a conductive transparent material. The conductive transparent material is desirably more flexible than a metal oxide when formed into a conductive layer.

Conventionally, there have been attempts to manufacture a highly flexible conductive transparent material by mixing a conductive polymer and a transparent polymer. However, such conventional conductive transparent materials exhibit a dramatic decrease in light transmittivity as the content of the conductive polymer in the mixture increases. Accordingly, a highly flexible transparent material is desired.

### SUMMARY OF THE INVENTION

To overcome the limitations of the prior art, in an embodiment, a manufacturing method of a conductive transparent material, which is highly conductive and transparent, is provided.

In another embodiment, a conductive transparent material which is highly conductive and transparent is provided.

In another embodiment, a display device which comprises highly conductive transparent material is provided.

Additional aspects and/or advantages of the present invention will be set forth in part in the description and embodiments which follow.

Thus, in an embodiment, a method of manufacturing a conductive transparent material comprises; providing a nano particle which comprises a core having a conductive polymer and a shell surrounding at least a part of the core and comprising a first transparent polymer; providing a mixture by mixing a base powder comprising a second transparent polymer and the nano particle; and forming a conductive network in which the cores are connected with each other, by pressing the mixture.

In an embodiment, the mixture is pressed at a higher temperature than a glass transition temperature of the first transparent polymer and a glass transition temperature of the second transparent polymer.

In an embodiment, the mixture is pressed so that the conductive transparent material forms a film.

In an embodiment, the first and second transparent polymers have the same material.

In an embodiment, the conductive polymer comprises polypyrrole, polyaniline, polythiophene, or a combination comprising at least one of the foregoing conductive polymers.

In an embodiment, the first transparent polymer comprises polymethylmethacrylate, polystyrene, polydivinylbenzene, polyvinylphenol, or a combination comprising at least one of the foregoing transparent polymers.

In an embodiment, the providing the nano particle comprises forming the core by supplying a core-forming monomer and a core-forming initiator to an emulsion which is formed with a micelle, and forming the shell by supplying a shell-forming initiator and a shell-forming monomer to the emulsion which is formed with the core.

In an embodiment, the core-forming initiator comprises FeCl₃.

In an embodiment, the core- forming monomer comprises pyrrole, and the number of moles of the core forming initiator is two to three times that of pyrrole.

In an embodiment, the micelle is generated from a cationic surfactant.

In an embodiment, the concentration of the cationic surfactant in the emulsion is 5wt% to 30wt%.

In an embodiment, the shell-forming initiator comprises a radical polymerization initiator.

In an embodiment, the shell-forming initiator comprises AIBN (2,2'-azobisisobutyronitrile, benzoyl peroxide (BPO), or a combination comprising at least one of the foregoing initiators.

In an embodiment, the providing the nano particle comprises providing a template which is formed with a pore having a diameter and a length of 200nm or less, respectively, forming the shell by supplying a shell-forming monomer to the pore, and forming the core by supplying a core-forming monomer to the pore formed with the shell.

In an embodiment, the monomer is vaporized before being supplied.

In an embodiment, the template comprises an anodic aluminum oxide membrane, wherein the method further comprises separating the nano particle from the template by etching the template.

In an embodiment, the core accounts for 20wt% to 40wt% of the total weight of the mixture.

In an embodiment, the size of the core is 10nm to 200nm, and the thickness of the shell is 1nm to 10nm.

In an embodiment, the core has a spherical shape, whose diameter is 15nm to 35nm.

The foregoing and/or other aspects can be achieved by providing a conductive transparent material, comprising a nano particle which comprises a core having a size of 10nm to 200nm and comprising a conductive polymer, and a shell partially surrounding the core and comprising a first transparent polymer, and a base which surrounds the nano particle and comprises a second transparent polymer.

In an embodiment, the conductive transparent material is provided as a film.

In an embodiment, the first and second transparent polymers comprise the same material.

In an embodiment, the conductive polymer comprises polypyrrole, polyaniline, polythiophene, or a combination comprising at least one of the foregoing conductive polymers.

In an embodiment, the first transparent polymer comprises polymethylmethacrylate, polystyrene, polydivinylbenzene, polyvinylphenol, or a combination comprising at least one of the foregoing transparent polymers.

In an embodiment, the core accounts for 20wt% to 40wt% of the total weight of the conductive transparent material.

In an embodiment, the thickness of the shell is 1nm to 10nm.

In an embodiment, the core has a spherical shape, whose diameter is 15nm to 35nm.

In an embodiment, a light transmittivity of the conductive transparent material is 80% or more when the nano particle is present in an amount of 20wt% or greater of the total weight of the conductive transparent material.

In an embodiment, the conductivity thereof is ten times higher when the nano particle is 25wt% than that when the nano particle is 15wt%.

The foregoing and/or other aspects can be achieved by providing a display device which comprises an insulating substrate and a transparent electrode formed on a surface of the insulating substrate, the transparent electrode comprising a nano particle which comprises a core having a size of 10nm to 200nm, comprising a conductive polymer and forming a conductive network, and a shell partially surrounding the core and comprising a first transparent polymer, and a base surrounding the nano particle and comprising a second transparent base polymer.

In an embodiment, the display device further comprises a thin film transistor which is formed on a surface of the insulating substrate and connected with the transparent electrode.

In an embodiment, the transparent electrode is formed by an imprint method.

In an embodiment, the transparent electrode is formed across the insulating substrate and receives a single voltage.

In an embodiment, the insulating substrate comprises a plastic material.

In an embodiment, the conductive polymer comprises polypyrrole, polyaniline, polythiophene, or a combination comprising at least one of the foregoing conductive polymers.

In an embodiment, the first transparent polymer comprises polymethylmethacrylate, polystyrene, polydivinylbenzene, polyvinylphenol, or a combination comprising at least one of the foregoing transparent polymers.

In an embodiment, the nano particle accounts for about 20wt% to 40wt% of the total weight of transparent electrode.

In an embodiment, the thickness of the shell is 1nm to 10nm.

In an embodiment, the core has a spherical shape, whose diameter is 15nm to 35nm.

### BRIEF DESCRIPTION OF THE DRAWINGS

The above and/or other aspects and advantages will become apparent and more readily appreciated from the following description of the embodiments, taken in conjunction with the accompany drawings of which:
FIG. 1 is a sectional view of a conductive transparent material according to a first embodiment;
FIGs. 2a to 2g illustrate manufacturing methods of the conductive transparent material according to the first embodiment;
FIG. 3 illustrates SEM and TEM images to explain a core/shell nano particle according to the first embodiment;
FIG. 4 is SEM images to explain the core/shell nano particle according to a supply ratio of pyrrole monomer/MMA monomer;
FIGS. 5a and 5b illustrate transmittivity of the conductive transparent material according to a state (i.e., oxidation state) of polypyrrole;
FIG. 6 illustrates conductivity of the conductive transparent material according to the state of polypyrrole;
FIG. 7 illustrates an SEM image of a broken surface of the conductive transparent material according to the state and content of polypyrrole;
FIG. 8 is a sectional view of a conductive transparent material according to a second embodiment;
FIGS. 9a to 9g illustrate manufacturing methods of the conductive transparent material according to the second embodiment;
FIG. 10 is a sectional view of a conductive transparent material according to a third embodiment;
FIG. 11 illustrates a sectional view of a liquid crystal display (LCD) device according to an embodiment;
FIG. 12 illustrates a manufacturing method of the LCD device according to the embodiment;
FIG. 13 is a sectional view of an organic light emitting diode (OLED) according to the embodiment; and
FIG. 14 is a perspective view of a monitor which employs the conductive transparent material according to the present invention.

### DETAILED DESCRIPTION OF EMBODIMENTS

Hereinafter, embodiments will be described with reference to accompanying drawings, wherein like numerals refer to like elements and repetitive descriptions will be avoided as necessary.

It will be understood in the following disclosure of the present invention, that as used herein, the singular forms "a", "an" and "the" are intended to include the plural forms as well, unless the context clearly indicates otherwise. It will be further understood that the terms "comprise", "comprises", and "comprising," when used in this specification, specify the presence of stated features, integers, steps, operations, elements, components, and combination of the foregoing, but do not preclude the presence and/or addition of one or more other features, integers, steps, operations, elements, components, groups, and combination of the foregoing.

It will be understood that when an element is referred to as being "on" another element, or when an element is referred to as being "disposed between" two or more other elements, it can be directly on (i.e., in at least partial contact with) the other element(s), or an intervening element or elements may be present therebetween. In contrast, when an element is referred to as being "disposed on" another element, the elements are understood to be in at least partial contact with each other, unless otherwise specified. Spatially relative terms, such as "between", "in between" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. The device may be otherwise oriented (rotated 90 degrees, inverted, or at other orientations) and the spatially relative descriptors used herein interpreted accordingly. Likewise, use of the term "opposite", unless otherwise specified, means on the opposing side or surface of the element. For example, where a surface of a layer is said to be opposite another surface or element, it is located on the opposing surface of the layer coplanar with the first surface unless otherwise specified.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As disclosed herein, a core/shell nano particle comprises a nano tube which is hollow and a nano wire (also referred to as a "nanofiber") which is solid. A core may comprise a tube structure or a solid structure.

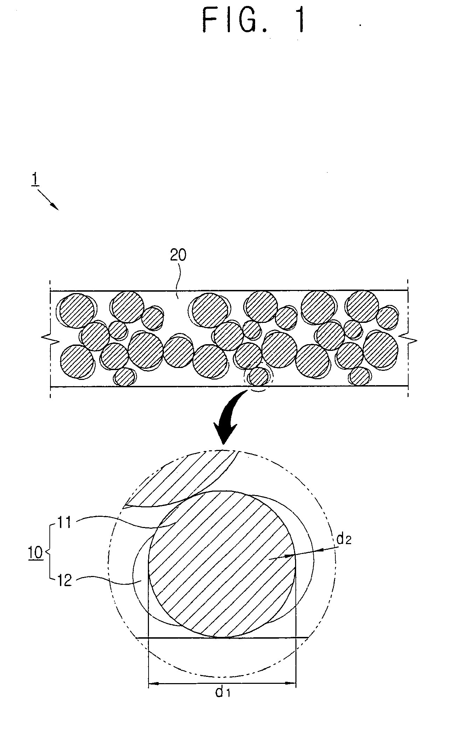

FIG. 1 is a sectional view of a conductive transparent material according to a first embodiment.

A conductive transparent material 1 is provided as a film. The conductive transparent material 1 comprises a core/shell nano particle 10 and a base 20.

The core/shell nano particle 10 comprises a core 11 and a shell 12 surrounding the core 11.

The core 11 has a spherical shape, whose diameter d1 ranges from 10nm to 200nm, preferably 15nm to 35nm. When the diameter d1 of the core 11 is 200nm or more, the core 11 becomes larger than half of the shortest wave of visible rays, thereby decreasing transparency of the conductive transparent material 1.

The shell 12 partially covers the core 11, and a thickness d2 thereof ranges from 1nm to 10nm.

The core 11 may comprise a conductive polymer, e.g., one of polypyrrole, polyaniline, or polythiophene. The cores 11 are connected with each other to form a conductive network. The conductive network is formed over the conductive transparent material 1 so that the conductive transparent material 1 becomes conductive.

The shell 12 may comprise a transparent polymer, e.g., one of polymethylmethacrylate, polystyrene, polydivinylbenzene, polyvinylphenol, or a combination comprising at least one of the foregoing transparent polymers. The shell 12 is excluded on a region where the cores 11 are connected with each other, allowing the conductive network to be formed.

The base 20 forms a continuous phase and covers the core/shell nano particle 10. The base 20 may comprise a transparent polymer, e.g., polymethylmethacrylate, polystyrene, polydivinylbenzene, polyvinylphenol, or a combination comprising at least one of the foregoing transparent polymers. Preferably, the base 20 is highly compatible with the shell 12. The base 20 and the shell 12 may comprise the same material.

The core 11 may account for 20wt% to 40wt% of the total weight of the overall conductive transparent material 1. Light transmittivity of the conductive transparent material 1 may vary according to a content of the core/shell nano particle 10. When the core/shell nano particle 10 is 20 wt%, the light transmittivity of the conductive transparent material 1 may be 80% or more.

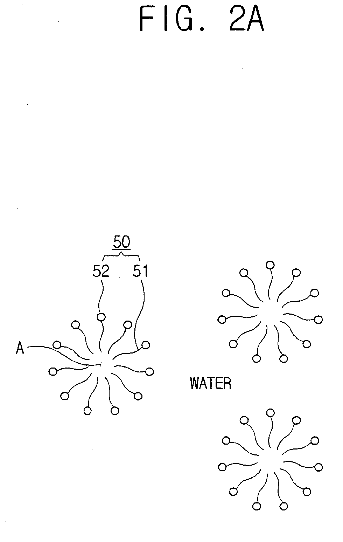

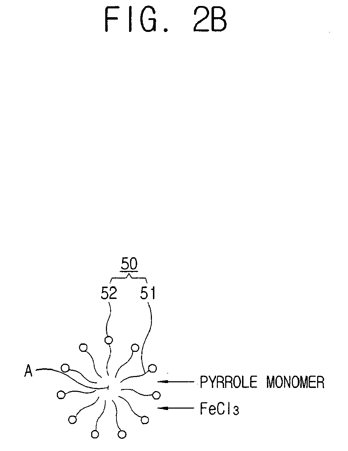

Referring to FIGS. 2a to 2g, manufacturing methods of the conductive transparent material according to a first embodiment will be described. As shown therein, the core 11 comprises polypyrrole. The shell 12 and the base 20 comprise polymethylmethacrylate ("PMMA").

As shown in FIG. 2a, a cationic surfactant 50 is added to water to form an oil-in-water emulsion having a micelle. The cationic surfactant 50 comprises a hydrophobic part 51 and a hydrophilic part 52. The hydrophilic part 52 is disposed around water, and the hydrophobic part 51 is disposed within the hydrophilic part 52 to define a free volume A.

The shape and size of the free volume A varies according to the type and amount of the cationic surfactant 50. The micelle according to the first embodiment defines the free volume A. The concentration of the cationic surfactant 50 in the emulsion may range from 5wt% to 30wt%. When the concentration of the cationic surfactant 50 is lower than 5wt%, the micelle is not readily formed. When the concentration of the cationic surfactant 50 is higher than 30wt%, the shape of the micelle is not controllable.

The cationic surfactant 50 according to the first embodiment may comprise alkyltrimethylammonium bromide, but not limited thereto. In an embodiment, an alkyl chain comprises 16 carbons or less to secure the free volume A.

The size of the core/shell nano particle 10 to be formed is adjustable according to the size of the free volume A and the amount of monomer. When the free volume A and the amount of monomer becomes larger, the core/shell nano particle 10 increases.

The micelle may be formed by using an anionic surfactant.

Then, the core/shell nano particle 10 is formed in the free volume A by performing two-stage polymerization, which will be described hereinafter.

As shown in FIG. 2b, the emulsion is mixed with a pyrrole monomer and FeCl₃ as an initiator. FeCl₃ is used for redox polymerization of the pyrrole monomer. The pyrrole monomer is polymerized within the free volume A. When FeCl₃ is used with over a certain amount during the polymerization, chloride ion provided by the FeCl₃ as a dopant to a polypyrrole polymer, generating a conductive polypyrrole. The amount of the FeCl₃ may be about two or three times that of the pyrrole monomer on a molar basis, specifically about 2.3 times the number of moles of pyrrole monomer.

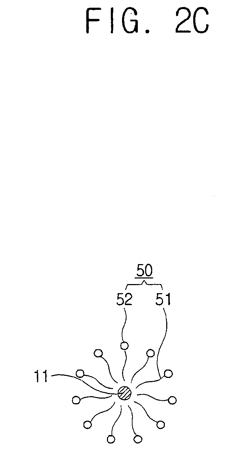

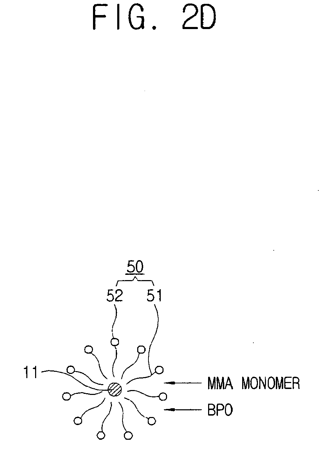

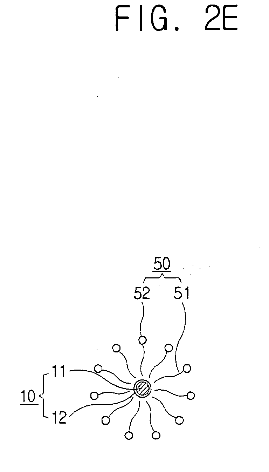

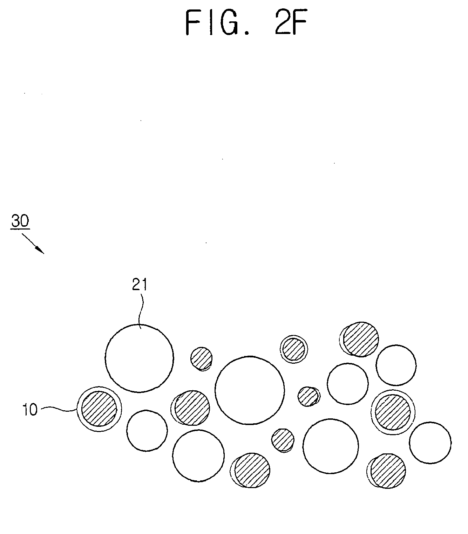

FIG. 2c illustrates a formation of the core 11 comprising polypyrrole through the polymerization of the pyrrole monomer. The core 11 may have a spherical shape according to the void shape defined by the free volume A.

As shown in FIG. 2d, a methylmethacrylate (MMA) monomer, benzoyl peroxide, or a combination comprising at least one of the foregoing initiators as a radical polymerization initiator is added to the core 11. Alternatively, the radical polymerization initiator may comprise AIBN (2,2'-azobisisobutyronitrile). The methylmethacrylate monomer is polymerized on a surface of the core 11 within the void having free volume A.

FIG. 2e illustrates a formation of the shell 12 comprising polymethylmethacrylate by polymerization of the methylmethacrylate monomer. The shell 12 may cover the core 11 partially or entirely. In this way, the core/shell nano particle 10 is completed.

As shown in FIG. 2f, a base powder 21 is then added to the core/shell nano particle 10 to form a mixture 30. The base powder 21 comprises polymethylmethacrylate.

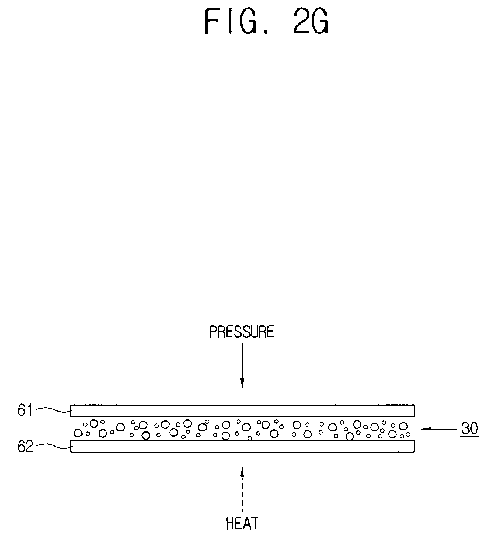

As shown in FIG. 2g, the mixture 30 is provided to and pressed by pressure molds 61 and 62. Here, the mixture 30 is pressed while being heated. The mixture 30 is heated to a higher temperature than a glass transition temperature Tg of the polymethylmethacrylate.

Polymethylmethacrylate is easily deformed at its glass transition temperature Tg or higher. The shell 12 and the base powder 21 which cover the cores 11 are deformed so that the cores 11 contact each other to form the conductive network.

The shell 12 is thick enough to be deformed during the pressing process, and expose the cores 11. Preferably, the thickness d2 of the shell 12 (refer to FIG. 1) ranges from 1nm to 10 nm. When the thickness d2 of the shell 12 is thinner than 1nm, the core/shell nano particle 10 is aggregated on a large scale, thereby lowering conductivity and transparency thereof. When the thickness d2 of the shell 12 is thicker than 10nm, the shell 12 is not easily deformed, thereby adversely affecting in forming the conductive network.

The base powder 21 is integrally formed during the pressing process to form the base 20.

When the shell 12 and the base 20 each comprise different materials than each other, a temperature applied to the mixture 30 is greater than the higher of either the glass transition temperature of the shell 12 or the glass transition temperature of the base 20.

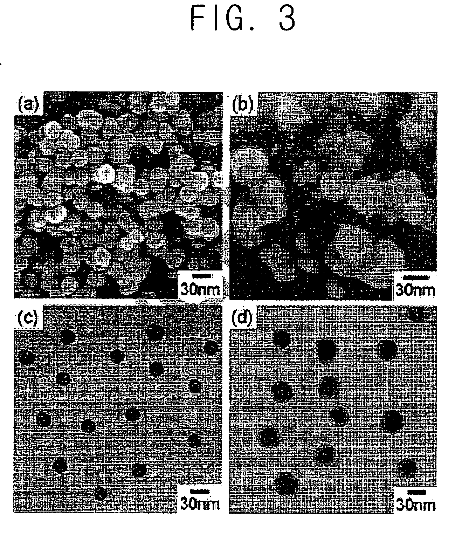

Referring to FIGS. 3 to 7, the core/shell nano particle 10 and the conductive transparent material 1 using the transparent polymer in each of the core/shell nanoparticle and the transparent conductive material will be described in detail.

FIG. 3 illustrates scanning electron microscope ("SEM") and transmission electron microscope ("TEM") images respectively to elucidate the core/shell nano particle 10 according to the first embodiment.

As shown therein, (a) and (c) are SEM and TEM images of the polypyrrole nano particle, respectively. (b) and (d) are each SEM and TEM images of the core/shell nano particle 10, respectively.

The polypyrrole nano particle in (a) and (c) is obtained by polymerizing the pyrrole monomer alone in the emulsion, which does not have a core-shell structure.

The core/shell nano particle 10 in (b) and (d) are produced by sequentially supplying the pyrrole monomer and methylmethacrylate according to the present invention, and thus has a core-shell structure. The molar ratio of the pyrrole monomer and the methylmethacrylate monomer present in the core/shell structure is 1:2.5.

As shown in FIG. 3, the surface of the polypyrrole nano particle is smooth while the surface of the core/shell nano particle 10 is rough, which is caused by low compatibility (i.e., miscibility) between polypyrrole and polymethylmethacrylate. Thus, the conductive network between the cores 11 is easily formed between the rough surfaces of the core/shell nanoparticle structures 10 while pressing the mixture 30 as shown in FIG. 2g.

As shown in FIG. 3, the core/shell nano particle has a core-shell structure unlike that of the polypyrrole nano particle.

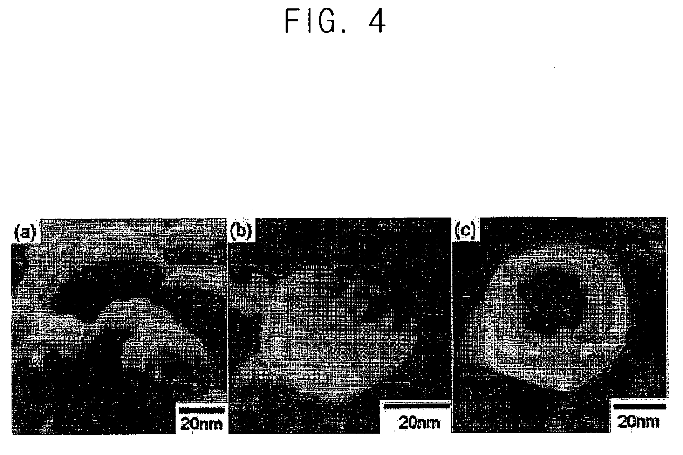

FIG. 4 shows SEM images to illustrate the core/shell nano particle 10 according to a molar supply ratio of pyrrole monomer/MMA monomer.

The molar supply ratio with respect to (a), (b) and (c) in FIG.4 is 1:1.25, 1:2.50 and 1:3.75, respectively.

As shown therein, when the amount of the methylmethacrylate monomer increases, the core/shell nano particle 10 becomes larger, and the surface thereof becomes smooth. However, the amount of methylmethacrylate is limited as the increased shell 12 comprising polymethylmethacrylate may adversely affect formation of the conductive network between the cores during pressing the mixture 30 as shown in FIG. 2g.

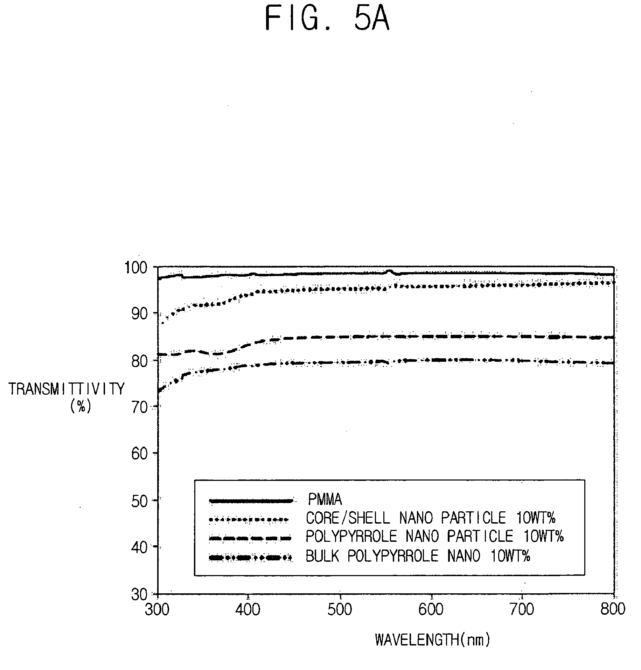

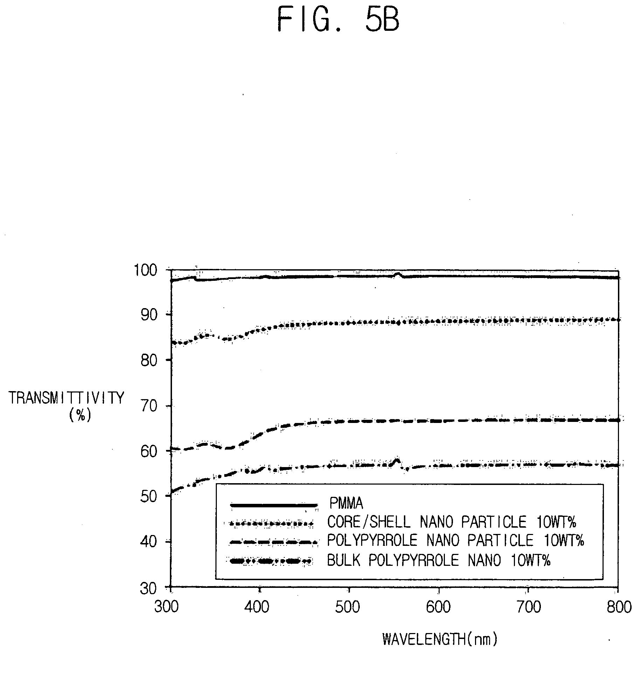

FIGS. 5a and 5b illustrate transmittivity of the conductive transparent material 1 according to the conductive state of polypyrrole. Four types of conductive transparent materials are used: polymethylmethacrylate as 100% of the transparent polymer, and three materials which are produced by adding polypyrrole in various states to polymethylmethacrylate powder, followed by pressing the materials.

The conductive transparent material 1 is produced by mixing polypyrrole and polymethylmethacrylate powder and pressing at 200°C for about ten minutes. The thickness of the conductive transparent material is approximately 20µm.

Hereinafter, the state of polypyrrole which is used to produce the conductive transparent material 1, will be described.

The core/shell nano particle 10 has a spherical shape. The core/shell nano particle 10 comprises the cores 11 having polypyrrole and the shell 12 having polymethylmethacrylate. The diameter of the cores 11 is about 25nm. The thickness of the shell 12 is about 3.5 nm. As shown in FIGS. 5a and 5b, the content of the core/shell nano particle 10 represents the content of the core having polypyrrole.

The polypyrrole nano particle is formed by polymerizing the pyrrole monomer separately from the polymerization of the emulsion, which does not have a shell. The polypyrrole nano particle has a spherical shape and the diameter thereof is about 25nm.

Bulk polypyrrole is generated by polymerizing the pyrrole monomer alone and without any surface active agent present. The bulk polypyrrole does not comprise a shell. The bulk polypyrrole has a spherical shape, the diameter of which is about 100nm to 200nm.

The core/shell nano particle 10 provides 90% or more of light transmittivity in most of visible ray areas when 10wt% of the core/shell nano particle 10 is used. The light transmittivity decreases when the core/shell nano particle is used in an amount of 20wt% or greater, based on the total weight of conductive transparent material. However, the core/shell nano particle 10 used at this level provides 80% or more of light transmittivity over the visible ray areas.

The polypyrrole nano particle and the bulk polypyrrole represent 10% lower transmittivity than the core/shell nano particle 10 when 10wt% or less of the polypyrrole nano particle and bulk polypyrrole are used, based on the total weight of conductive transparent material. When 20wt% or greater of the polypyrrole nano particle and the bulk polypyrrole are used, based on the total weight of conductive transparent material, the light transmittivity thereof decreases further.

The core/shell nano particle 10 has high light transmittivity since the shell 12 and the base 20 have comparable refractive indices and are highly compatible with each other. The polypyrrole nano particle and the bulk polypyrrole have lower compatibility with the base 20, thereby providing low light transmittivity. Particularly, bulk polypyrrole has a large particle, so that it has much lower light transmittivity than others.

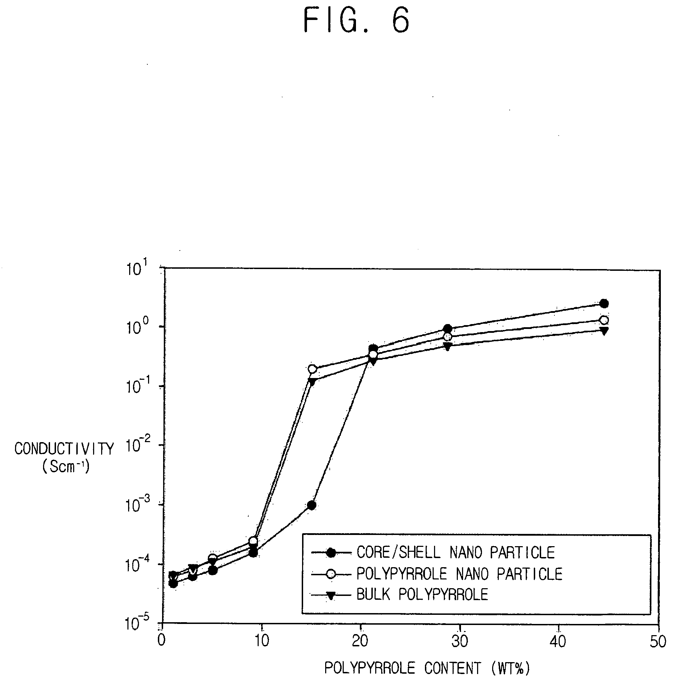

FIG. 6 illustrates a conductivity of the conductive transparent material 1 according to the state of the polypyrrole. The state of polypyrrole is the same as that in FIGS. 5a and 5b.

The three materials all show a percolation threshold (i.e., the concentration at which conductance in the conductive transparent material becomes nonzero) as the content of polypyrrole increases. At the percolation threshold, the conductivity drastically increases, e.g., about 1,000 times.

The percolation threshold is shown when 10wt% to 15wt% of the polypyrrole nano particle and bulk polypyrrole are used. The percolation threshold when 15wt% to 20wt% of the core/shell nano particle, based on the total weight of each of the conductive transparent electrodes is used is also shown. The conductivity of the conductive transparent material 1 is 10 times higher when using 25wt% of the core/shell nano particle 10 than when using 15wt% thereof, based on the total weight of each of the conductive transparent electrode.

The core/shell nano particle 10 having the shell 12 as an insulating material shows the percolation threshold which is only 5% higher than that of the polypyrrole nano particle and bulk polypyrrole. This is because the thickness of the shell 12 is 1nm to 10nm and thus the shell 12 is more influenced by heating than the base 20.

The core/shell nano particle 10 has the highest conductivity above the percolation threshold.

Based on the foregoing results, the cores 11 account for 20wt% to 40wt% of the total weight of conductive transparent material 1. When the content of the cores 11 is 20wt% or less, the percolation threshold is not reached, thereby lowering the conductivity thereof. When the content of the cores 11 is 40wt% or more, the transmittivity decreases while the conductivity does not increase further. The content of the cores 11 may be adjusted according to materials of the cores 11, the shell 12 and the base 20, the size of the cores 11, the thickness of the shell 12 and the pressure conditions.

The shell 12 prevents the core/shell nano particle 10 from being oxidized. Thus, reduction in the conductivity of the conductive transparent material 1 is inhibited. While the conductivity of the conductive transparent material 1 comprising the polypyrrole nano particle decreases 100 times to 1000 times, the conductivity of the conductive transparent material 1 using the core/shell nano particle 10 shows a decrease of 10 times or less.

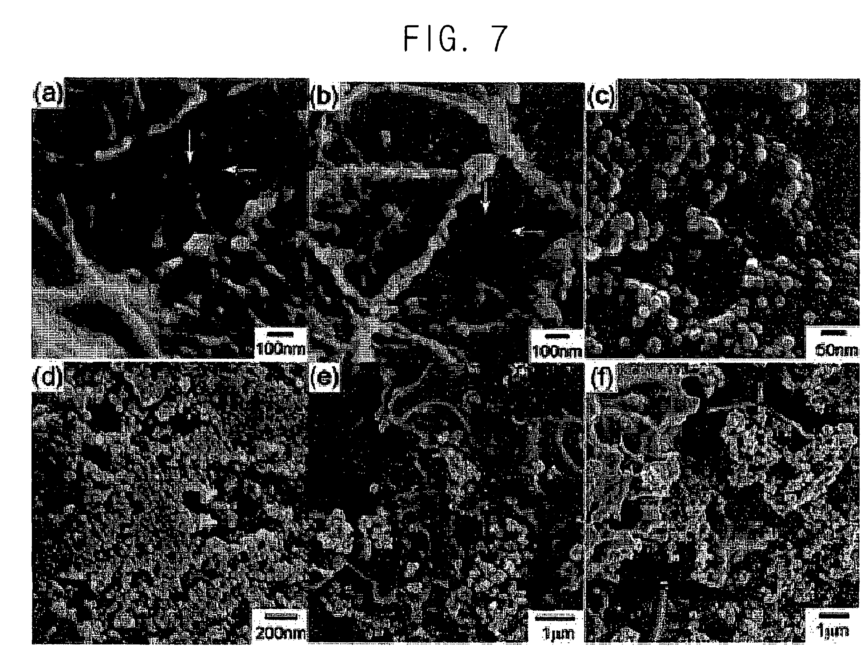

FIG. 7 shows SEM images of a broken surface of the conductive transparent material according to the oxidative state and content of polypyrrole.

(a) and (b) in FIG. 7 illustrate the conductive transparent material 1 comprising the core/shell nano particle 10. The content of the core/shell nano particle 10 in (a) and (b) is 10wt% and 20wt%, based on the total weight of each of these electrodes, respectively.

(c) and (d) in FIG. 7 illustrate the conductive transparent material 1 comprising the polypyrrole nano particle. The content of the polypyrrole nano particle of (c) and (d) is 10wt% and 20wt%, based on the total weight of each of these electrodes, respectively.

(e) and (f) in FIG. 7 illustrate the conductive transparent material 1 comprising bulk polypyrrole. The content of bulk polypyrrole of (e) and (f) is 10wt% and 20wt%, based on the total weight of each of these electrodes, respectively.

As indicated by arrows in (a) and (b), the conductive network forms uniformly in the conductive transparent material 1 comprising the core/shell nano particle 10. However, as shown in (c) to (f), the polypyrrole nano particle and bulk polypyrrole fail to form the conductive network while conglomerating each other.

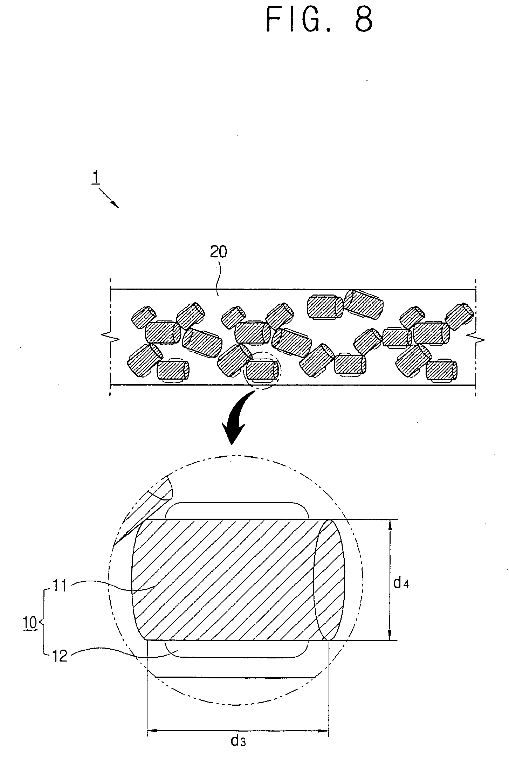

FIG. 8 is a sectional view of a conductive transparent material 1 according to a second embodiment.

As the material of a core 11, a shell 12 and a base 20 is the same as that according to the first embodiment, the description thereof will be omitted here. The cores 11 are connected with each other and form a conductive network. The conductive network is formed over the conductive transparent material 1, thereby providing conductivity to the conductive transparent material 1.

A core/shell nano material 10 which comprises the cores 11 and the shell 12, has a cylindrical shape. A height d3 and a diameter d4 of the cores 11 is 200nm or less, respectively.

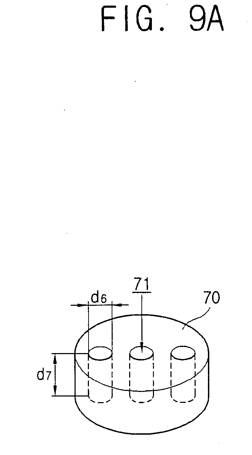

Hereinafter, manufacturing methods of the conductive transparent material 1 according to the second embodiment will be described with reference to FIGS. 9a to 9g.

The conductive transparent material 1 according to the second embodiment is manufactured by two-stage polymerization like that according to the first embodiment. However, in the conductive transparent material 1 according to the second embodiment, the shell 12 is formed earlier than the cores 11.

As shown in FIG. 9a, a template 70 which is formed with a plurality of pores 71 is provided. A diameter d6 and a height d7 of the pores 71 is 200nm or less, respectively. The mold 70 may comprise an anodic aluminum oxide membrane, but is not limited thereto.

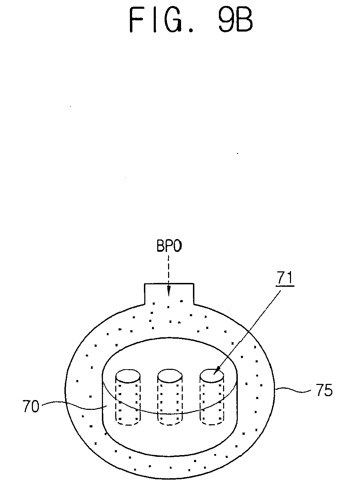

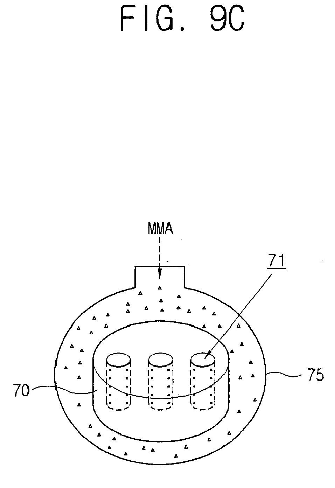

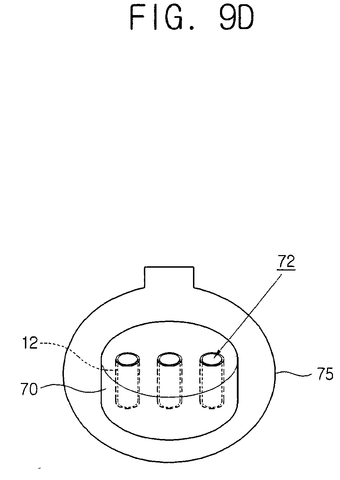

As shown in FIG. 9b, the template 70 is disposed in a vacuum container 75, and then benzoyl peroxide (BPO) as a radical polymerization initiator is supplied to the pores 71. In an embodiment, the vacuum level in the vacuum container 75 is 10⁻² torr or less during the process.

BPO as a vapor is supplied to the pores 71, but not limited thereto. Alternatively, BPO may be dissolved in a solvent and then supplied to the pores 71.

As shown in FIG. 9c, a methylmethacrylate monomer as a gas is supplied to the pores 71. When the methylmethacrylate monomer is liquid or solid, the methylmethacrylate monomer is vaporized by vacuum and heat. The methylmethacrylate monomer is polymerized within the pores 71 and attached to the surface of a wall of the pores 71. The template 70 may be heated to 50°C to 200°C according to the specific monomer present while polymerizing.

As shown in FIG. 9d, the shell 12 is formed within the pores 71 by polymerizing the methylmethacrylate monomer. When forming the shell 12, the amount of methylmethacrylate monomer is adjusted so that the pores 71 are not filled with the shell 12.

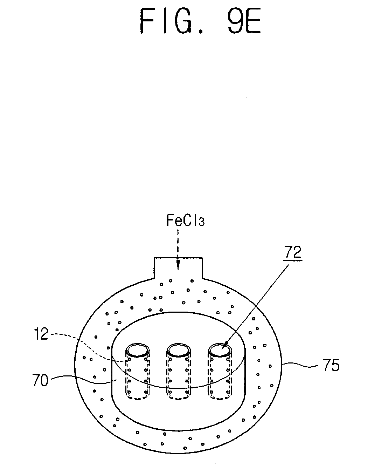

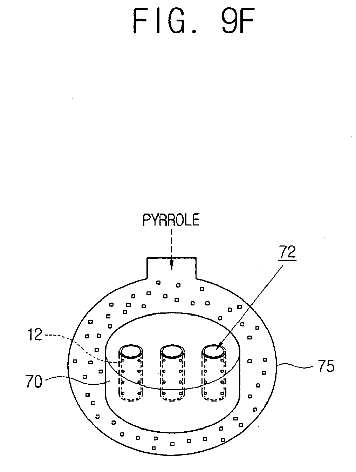

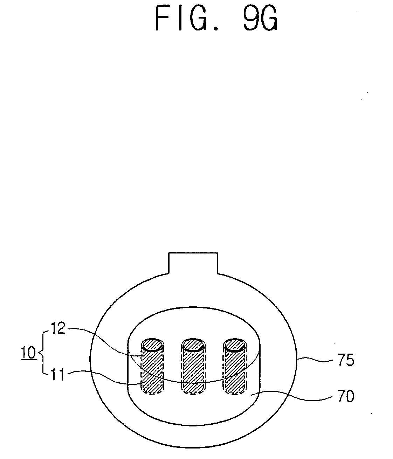

As shown in FIG. 9e, FeCl₃ as a redox polymerization initiator is supplied to pores 72. As the pores 72 are surrounded by the shell 12, the diameter of the pores 72 decreases. When FeCl₃ is supplied at or above a specific threshold amount, chloride provided by the FeCl₃ acts as a dopant for the conductive polymer, thereby allowing conductivity in the polymer. When FeCl₃ is supplied at less than the specific amount, the polymer does develop conductivity and becomes an organic semiconductor.

As shown in FIG. 9f, a pyrrole monomer as a vapor is supplied to the pores 72. When the pyrrole monomer is liquid or solid at a room temperature, the pyrrole monomer is vaporized by vacuuming and heat. The pyrrole monomer reacts within the pores 72. The template 70 may be heated to 50°C to 200°C according to the specific monomer being polymerized.

As shown in FIG. 9g, the cores 11 comprising polypyrrole are formed within the pores 72 by polymerizing the pyrrole monomer, thereby completing the core/shell nano particle 10.

Then, the core/shell nano particle 10 is separated from the template 70. When the template 70 comprises an anodic aluminum oxide membrane, the template 70 is etched with hydrochloric acid so that the core/shell nano particle 10 is separated from the template 70.

The core/shell nano particle 10 is mixed with a base powder 21 to form the conductive transparent material 1 after being pressed, as shown in FIGS. 2f and 2g.

The foregoing embodiments may vary. For example, the template 70 may be dipped into a FeCl₃ aqueous solution. Also, materials which remain in the pores 71 and 72 may be removed by vacuuming before supplying other materials.

The manufacturing method of the core/shell nano particle which uses the template 70 has following strengths: First, a solution is not necessary by using gaseous polymerization, and a recovery is not needed after polymerization. Second, the thickness of the core/shell nano particle 10 can be adjustable by using gaseous polymerization.

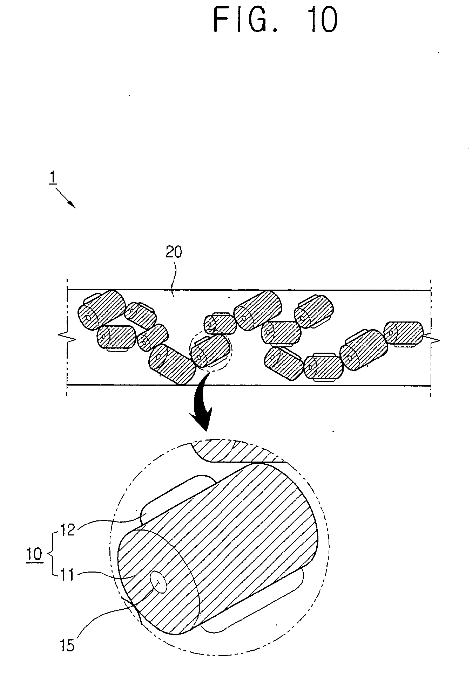

FIG. 10 is a sectional view of a conductive transparent material 1 according to a third embodiment.

As the material of a core 11, a shell 12 and a base 20 is the same as that according to the first embodiment, the description thereof will be omitted here. The cores 11 are connected with each other and form a conductive network. The conductive network is formed over the conductive transparent material 1 so that the conductive transparent material 1 has conductivity.

A core/shell nano particle 10 which comprises the cores 11 and the shell 12, has a cylindrical shape. In an embodiment, the cores 11 comprise a tube, which is hollow.

As shown in FIGS. 9a to 9g, the core/shell nano particle 10 according to the third embodiment may be manufactured by using a template. A tube structure core may be generated by decreasing the amount of a monomer.

The shape of the core/shell nano particle 10 according to the third embodiment may vary. The cores 11 and the shell 12 which have different materials each other, may be provided as double-layered structure. The shape of the core/shell nano particle may be a fibril, dendrite, or the like.

The conductive transparent material 1 may be used in a display device. Hereinafter, a method of applying the conductive transparent material 1 will be described.

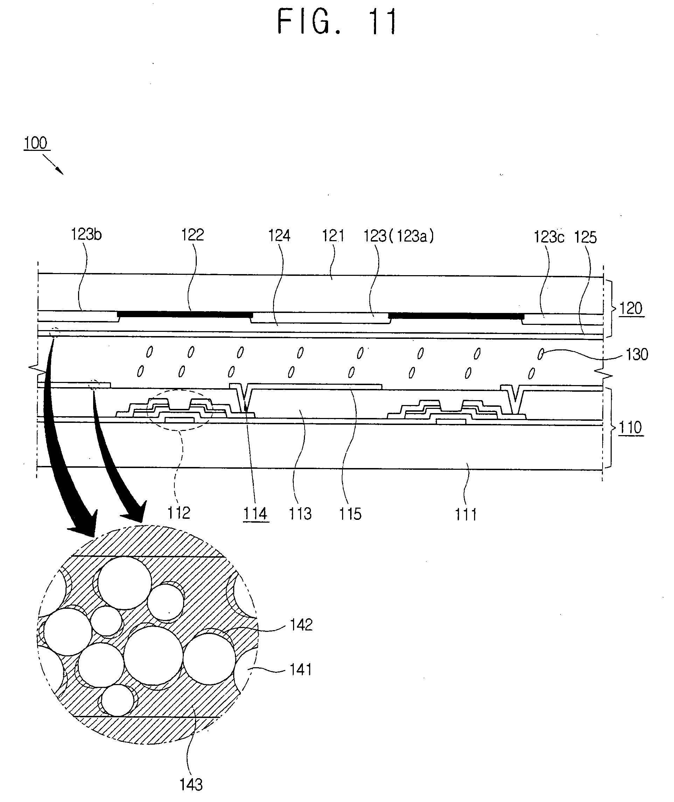

FIG. 11 illustrates a liquid crystal display (LCD) device according to an embodiment.

A liquid crystal display device 100 which is manufactured according to the method comprises a thin film transistor substrate 110, a color filter substrate 120 and a liquid crystal layer 130 which is interposed between the thin film transistor substrate 110 and the color filter substrate 120.

A plurality of thin film transistors 112 are formed on a surface of an insulating substrate 111 of the thin film transistor substrate 110. A surface of the thin film transistors 112 are covered by a passivation layer 113 opposite insulating substrate 111. A part of the passivation layer 113 is removed to form a contact hole 114 through which portions of the thin film transistors 112 are exposed. A pixel electrode 115 is disposed on a surface of the insulating layer 113 opposite the thin film transistors 112, where the pixel electrode 115 is both transparent and conductive. The pixel electrode 115 is connected with the thin film transistors 112 through the contact hole 114.

A black matrix 122 which has a grid shape is formed on a surface of an insulating substrate 121 of the color filter substrate 120. The black matrix 122 may comprise an organic material which has a black pigment. The placement of the black matrix 122 within the layered structure of the liquid crystal display device 100, corresponds to (i.e., coincides with the vertically stacked placement of) the thin film transistor 112 of the thin film transistor substrate 110 and wires (not shown), where the placement of the black matrix 112 and the thin film transistor 112 are aligned to a line orthogonal to the plane of the liquid crystal display 100, which traverses the smallest (i.e., thickness) dimension of the liquid crystal display 100.

A color filter layer 123 is formed on a surface of the insulating substrate 121 between the black matrixes 122. The color filter layer 123 comprises an organic material. The color filter layer 123 comprises three sub layers 123a, 123b and 123c, disposed on the insulating substrate adjacent to the black matrixes 122, and each of which has different colors than each other. An overcoat layer 124 is formed on a surface of the color filter layer 123 and black matrixes 122 opposite the insulating layer 121, and a common electrode 125, which is transparent and conductive, is formed on the overcoat layer 124 opposite black matrixes 122 and the color filter layer 123.

The molecular arrangement of a liquid crystal layer 130 formed between the surface of the thin film transistor substrate 110 having the pixel electrodes 115 thereon, and the surface of the color filter substrate 120 having the common electrode 125 thereon, is determined by an electric field formed by applying a potential across the pixel electrode 115 and the common electrode 125. The liquid crystal layer 130 determines transmittivity of light supplied from the thin film transistor substrate 110, and a polarizing plate (not shown), which is attached to the color filter layer 123 and the color filter substrate 120, assigns colors to the light.

At least one of the insulating substrates 111 and 121 of the liquid crystal display device 100 may comprise a plastic material. The plastic may comprise polycarbonate, polycarbon, polyamide, polyethersulfone ("PES"), polyarylate ("PAR"), polyethylene-naphthalate ("PEN") and polyethylene terephthalate ("PET").

The pixel electrode 115 and the common electrode 125 of the liquid crystal display device 100 comprise the conductive transparent material 1 according to the present invention. The pixel electrode 115 and the common electrode 125 comprise a conductive polymer. The pixel electrode 115 and the common electrode 125 comprise a core 141 which forms a conductive network; a shell 142 which partially covers the core 141 and comprises a transparent polymer; and a base 143 which forms a continuous phase and comprises a transparent polymer.

The core 141 accounts for 20wt% to 40wt% of the total weight of each of the pixel electrode 115 and the common electrode 125, based on the total weight of each of these electrodes, and light transmittivity thereof may be 80% or more.

The pixel electrode 115 and the common electrode 125 according to the present invention provide better conductivity and flexibility than a pixel electrode and a common electrode which comprise indium tin oxide (ITO) and indium zinc oxide (IZO). When the insulating substrates 111 and 121 comprise a plastic material to provide flexibility to the liquid crystal display device 100, the pixel electrode 115 and the common electrode 125 according to the present invention are not damaged by deformation of the insulating substrates 111 and 121.

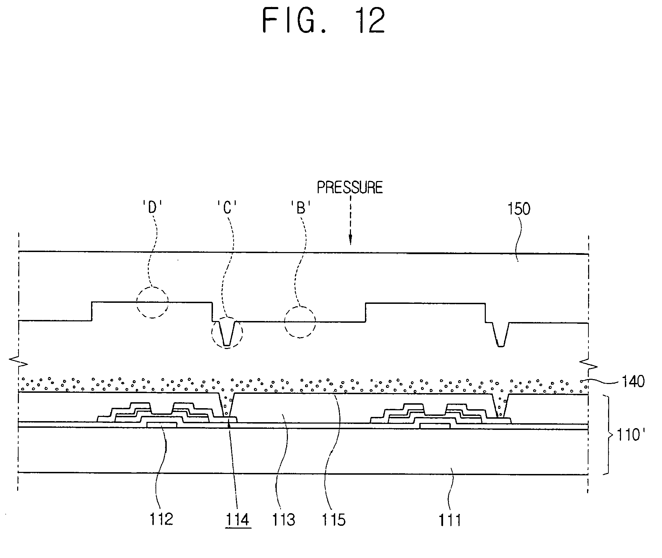

FIG. 12 illustrates manufacturing methods of the liquid crystal display device according to the embodiment.

The plurality of thin film transistors 112 are formed on a surface of the insulating substrate 111, and the passivation layer 113 is formed on a surface of the thin film transistors 112 opposite the insulating substrate 111, by a typical method. A part of the passivation layer 113 is removed to form the contact hole 114 through which a portion of the thin film transistors 112 are exposed.

A mixing powder 140 in which the core/shell nano particle 10 and the base powder 21 are mixed is applied to a surface of the passivation layer 113 opposite the thin film transistors 112.

The mixing powder 140 is heated while pressing the mold 150 to the surface of the passivation layer 113 having the mixing powder 140 disposed thereon, opposite the insulating substrate 111. The mold 150 comprises a B portion which protrudes from a surface of the mold 150 and corresponds to a region on the thin film transistor substrate 110' in which the pixel electrode 115 is formed; a C portion which corresponds to the contact hole 114 and protrudes further from the surface of mold 150 than the B portion; and a D portion which corresponds to a region of the thin film transistor substrate 110' in which the pixel electrode 115 is not formed and is recessed.

The mixing powder 140 forms a transparent layer on thin film transistor substrate 110' by pressing the mold 150 onto the thin film transistor substrate 110' coated with the mixing powder 140. As the mixing powder 140 corresponding to the B and C portions of the mold 150 is pressed, the core 141 forms a conductive network. The mixing powder 140 corresponding to the D portion of the mold 150 is not properly pressed so that the core 141 does not form the conductive network. The transparent layer corresponding to the region in which the pixel electrode 115 is not formed, is selectively dry-etched using a mask and is removed.

Additional dry-etching may be omitted if there is a low possibility for forming the conductive network by the core 141 in a region in which the pixel electrode 115 is not disposed. In this case, the transparent layer formed by pressing the mixing powder 140 is formed across the passivation layer 113 while the pixel electrode 115 formed with the conductive network is electrically separated in each pixel.

The mixing powder 140 corresponding to the D portion of the mold 150 may form the conductive network partially by heating. Unlike the present embodiment, the core 141 may form the conductive network across the mixing powder 140 unless the D portion is additionally provided in the mold 150. When the conductive network is formed in the mixing powder 140 corresponding to the D portion, the transparent layer formed between the pixel electrodes 115 is removed.

The common electrode 125 is formed on the overcoat layer 124 by applying the mixing powder 140 thereon and heating and pressing. Alternatively, a film-shaped conductive transparent material may be attached to the overcoat layer 124.

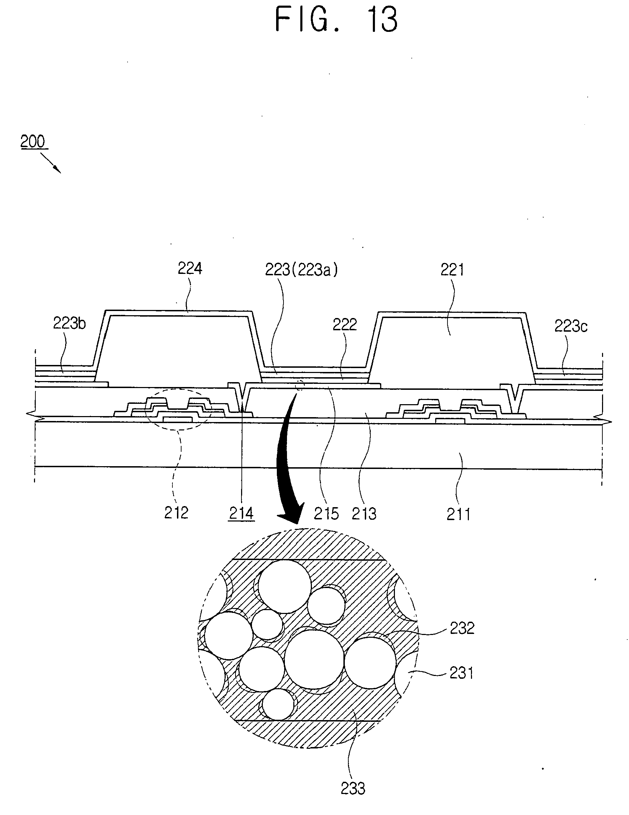

FIG. 13 is a sectional view of an organic light emitting diode ("OLED") according to the embodiment.

The OLED comprises a plurality of thin film transistors 212 which include switching transistors Tsw and driving transistors Tdr. FIG. 13 illustrates a driving transistor (i.e., thin film transistor 212) alone which is connected with the pixel electrode 215.

The plurality of thin film transistors 212 is formed on a surface of an insulating substrate 211.

The insulating substrate 211 may comprise glass or plastic. The plastic may comprise polycarbonate, polycarbon, polyamide, PES, PAR, PEN, PET, or the like.

A passivation layer 213 covers a surface of the thin film transistors 212 opposite the insulating substrate 211. A part of the passivation layer 213 is removed to form a contact hole 214 through which portions of the thin film transistors 212 are exposed. A pixel electrode 215, formed on a surface of the passivation layer 213 opposite the thin film transistors 212, is transparent and conductive. The pixel electrode 215 is connected with the thin film transistors 212 through the contact hole 214.

A wall 221 is formed on a surface of the passivation layer 213 between the pixel electrodes 215 and over the thin film transistor 212. The wall 221 divides the pixel electrode 215 to form a pixel region. The wall 221 comprises a photosensitive material based on a polymeric material such as an acrylic resin or polyamide resin, and which is resistant to heat and solvent.

Organic layer 222 is formed on a surface of the pixel electrode 215, and organic layer 223 is formed on a surface of the organic layer 222 opposite the pixel electrode 215. The organic layers 222 and 223 comprise and are referred to herein as hole injecting layer 222 and light emitting layer 223.

The hole injecting layer 222 can comprise a mixture of a polythiophene derivative such as poly(3,4-ethylenedeoxythiopene) ("PEDOT") and polystyrene sulfonic acid ("PSS").

The light emitting layer 223 comprises a red light emitting layer 223a which emits red light; a green light emitting layer 223b which emits green light; and a blue light emitting layer 223c which emits blue light.

The light emitting layer 223 may use a poly fluorene derivative; a (poly)paraphenylenevinylene derivative; a polyphenylene derivative; polyvinylcarbazole; and poly thiophene. Further, these polymer materials can be used when doped with a pigment such as a perylene pigment; a rhodamine pigment; rubrene; perylene; 9,10-diphenylanthracene; tetraphenylbutadiene; Nile red; coumarin 6; Quinacridone, or the like.

A hole transmitted from the pixel electrode 215 is combined with an electron supplied from a common electrode 224 in the light emitting layer 223, thereby creating an exciton and emitting light during the deactivation process of the exciton.

The common electrode 224 is provided on the wall 221 and the light emitting layer 223. The common electrode 224 supplies an electron to the light emitting layer 223. The common electrode 224 may be stacked with a lithium fluoride layer and an aluminum layer.

The pixel electrode 215 of the OLED 200 comprises the conductive transparent material 1 according to the present invention. The pixel electrode 215 comprises a core 231 which comprises a conductive polymer and forms a conductive network; a shell 232 which partially covers the core 231 and comprises a transparent polymer; and a base 233 which forms a continuous phase and comprises a transparent polymer.

The core 231 accounts for 20wt% to 40wt% of the pixel electrode 215, based on the total weight of the pixel electrode. Light transmittivity thereof may be 80% or more.

The manufacturing method of the pixel electrode 215 is the same as that described for the pixel electrode 115 in FIG. 12.

The conductive transparent material 1 is used as an electrode of the LCD and OLED, by way of example. Also, the conductive transparent material may be used as a pixel electrode and/or a common electrode of an electrophoresis display device ("EPD").

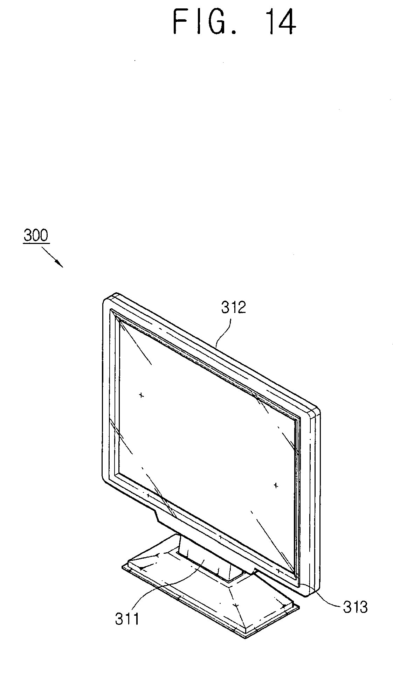

FIG. 14 illustrates a monitor which employs the conductive transparent material 1 according to the first embodiment.

A monitor 300 comprises a supporter 311 and a display part 312. The display part 312 may comprise a liquid crystal display (LCD) or an organic light emitting diode (OLED). An electromagnetic wave shielding plate 313 is provided on the display part 312. The electromagnetic wave shielding plate 313 comprises the conductive transparent material 1 according to the present invention.

The electromagnetic wave shielding plate 313 blocks electromagnetic waves generated by the display part 312, which is not to be transmitted to a user and from which the user is shielded.

The electromagnetic wave shielding plate 313 which comprises the conductive transparent material 1, provides good light transmittivity, thereby securing the quality of the display part 312. Also, the electromagnetic wave shielding plate 313 provides good conductivity and blocks electromagnetic waves effectively.

The electromagnetic wave shielding plate 313 may be used in television as well as a monitor.

As described above, the present invention provides a conductive transparent material which provides high transparency and conductivity, and a manufacturing method thereof.

Also, the present invention provides a display device which comprises a conductive transparent material having high transparency and conductivity.

Although a few embodiments have been shown and described, it will be appreciated by those skilled in the art that changes may be made in these embodiments without departing from the principles and spirit of the invention, the scope of which is defined in the appended claims.

## Claims

1. A method of manufacturing a conductive transparent material, comprising:
providing a nano particle which comprises a core having a conductive polymer and a shell surrounding at least a part of the core and comprising a first transparent polymer;
providing a mixture by mixing a base powder comprising a second transparent polymer and the nano particle; and
forming a conductive network in which the cores are connected with each other, by pressing the mixture.

2. The method according to claim 1, wherein the mixture is pressed at a higher temperature than a glass transition temperature of the first transparent polymer and a glass transition temperature of the second transparent polymer.

3. The method according to claim 2, wherein the mixture is pressed so that the conductive transparent material forms a film.

4. The method according to claim 3, wherein the first and second transparent polymers are the same.

5. The method according to claim 1, wherein the conductive polymer comprises polypyrrole, polyaniline, polythiophene, or a combination comprising at least one of the foregoing conductive polymers.

6. The method according to claim 5, wherein the first transparent polymer comprises polymethylmethacrylate, polystyrene, polydivinylbenzene, polyvinylphenol, or a combination comprising at least one of the foregoing transparent polymers.

7. The method according to claim 5, wherein the providing the nano particle comprises:
forming the core by supplying a core-forming monomer and a core-forming initiator to an emulsion which is formed with a micelle; and
forming the shell by supplying a shell-forming initiator and a shell-forming monomer to the emulsion which is formed with the core.

8. The method according to claim 7, wherein the core-forming initiator comprises FeCl₃.

9. The method according to claim 8, wherein the core-forming monomer comprises pyrrole, and the number of moles of the core forming initiator is two to three times that of pyrrole.

10. The method according to claim 7, wherein the micelle is generated from a cationic surfactant.

11. The method according to claim 10, wherein the concentration of the cationic surfactant in the emulsion is 5wt% to 30wt%.

12. The method according to claim 7, wherein the shell-forming initiator comprises a radical polymerization initiator.

13. The method according to claim 12, wherein the shell-forming initiator comprises AIBN(2,2'-azobisisobutyronitrile, benzoyl peroxide (BPO), or a combination comprising at least one of these initiators.

14. The method according to claim 5, wherein the providing the nano particle comprises:
providing a template with a pore having a diameter and a length of 200nm or less, respectively;
forming the shell by supplying a shell-forming monomer to the pore; and
forming the core by supplying a core-forming monomer to the pore formed with the shell.

15. The method according to claim 14, wherein the monomer is vaporized before being supplied.

16. The method according to claim 14, wherein the template comprises an anodic aluminum oxide membrane, and wherein the method further comprises:
separating the nano particle from the template by etching the template.

17. The method according to claim 5, wherein the core accounts for 20wt% to 40wt% of the total weight of the mixture.

18. The method according to claim 17, wherein the size of the core is 10nm to 200nm, and the thickness of the shell is 1nm to 10nm.

19. The method according to claim 18, wherein the core has a spherical shape, whose diameter is 15nm to 35nm.

20. A conductive transparent material, comprising:
a nano particle which comprises a core having a size of 10nm to 200nm and comprising a conductive polymer, and a shell partially surrounding the core and comprising a first transparent polymer; and
a base which surrounds the nano particle and comprises a second transparent polymer.

21. The conductive transparent material according to claim 20, wherein the conductive transparent material is provided as a film.

22. The conductive transparent material according to claim 20, wherein the first and second transparent polymers comprise the same material.

23. The conductive transparent material according to claim 20, wherein the conductive polymer comprises polypyrrole, polyaniline, polythiophene, or a combination comprising at least one of the foregoing conductive polymers.

24. The conductive transparent material according to claim 23, wherein the first transparent polymer comprises polymethylmethacrylate, polystyrene, polydivinylbenzene, polyvinylphenol, or a combination comprising at least one of the foregoing transparent polymers.

25. The conductive transparent material according to claim 20, wherein the core accounts for 20wt% to 40wt% of the total weight of the conductive transparent material.

26. The conductive transparent material according to claim 25, wherein the thickness of the shell is 1nm to 10nm.

27. The conductive transparent material according to claim 26, wherein the core has a spherical shape, whose diameter is 15nm to 35nm.

28. The conductive transparent material according to claim 20, wherein a light transmittivity of the conductive transparent material is 80% or more when the nano particle is 20wt% or greater based on the total weight of conductive transparent material.

29. The conductive transparent material according to claim 20, wherein the conductivity thereof is ten times higher than when the nano particle is present in an amount of 25wt% than that when the nano particle is present in an amount of 15wt%.

30. A display device which comprises an insulating substrate and a transparent electrode formed on a surface of the insulating substrate, the transparent electrode comprising:
a nano particle which comprises a core having a size of 10nm to 200nm, comprising a conductive polymer and forming a conductive network, and a shell partially surrounding the core and comprising a first transparent polymer, and a base surrounding the nano particle and comprising a second transparent base polymer.

31. The display device according to claim 30, further comprising a thin film transistor which is formed on a surface of the insulating substrate and connected with the transparent electrode.

32. The display device according to claim 31, wherein the transparent electrode is formed by an imprint method.

33. The display device according to claim 30, wherein the transparent electrode is formed across the insulating substrate and receives a single voltage.

34. The display device according to claim 30, wherein the insulating substrate comprises a plastic material.

35. The display device according to claim 30, wherein the conductive polymer comprises polypyrrole, polyaniline, polythiophene, or a combination comprising at least one of the foregoing conductive polymers.

36. The display device according to claim 35, wherein the first transparent polymer comprises polymethylmethacrylate, polystyrene, polydivinylbenzene, polyvinylphenol, or a combination comprising at least one of the foregoing transparent polymers.

37. The display device according to claim 35, wherein the nano particle accounts for about 20wt% to 40wt% of the total weight of the transparent electrode.

38. The display device according to claim 37, wherein the thickness of the shell is 1nm to 10nm.

39. The display device according to claim 38, wherein the core has a spherical shape, whose diameter is 15nm to 35nm.
